# EUROPEAN PATENT APPLICATION

(11) **EP 4 738 435 A1**
(43) Date of publication of application: **06.05.2026**
(21) Application number: 24919838.3
(22) Date of filing: 31.10.2024
(51) Int. Cl.: H01L 23/367

(54) **ELECTRONIC ASSEMBLY, ELECTRONIC DEVICE AND CHIP STRUCTURE**

(30) Priority: 23.01.2024 CN 202410099181
(71) Applicant: Huawei Technologies Co., Ltd., Shenzhen, Guangdong 518129 (CN)
(72) Inventor: WANG, Shaolei, Shenzhen, Guangdong 518129 (CN); ZHANG, Wei, Shenzhen, Guangdong 518129 (CN); YUAN, Lingcheng, Shenzhen, Guangdong 518129 (CN); WANG, Liangmeng, Shenzhen, Guangdong 518129 (CN)
(74) Representative: Grünecker Patent- und Rechtsanwälte PartG mbB
(86) International application number: PCT/CN2024/129098
(87) International publication number: WO 2025/156758

(57) **Abstract**

This application provides an electronic assembly, an electronic device, and a chip structure, and relates to the field of packaging technologies, to improve a heat dissipation capability of the electronic assembly. The electronic assembly includes a circuit board, a first chip, a second chip, and a heat transfer plate. The heat transfer plate is located on a side of the circuit board. The first chip is located between the heat transfer plate and the circuit board, the first chip is connected to the circuit board, and the first chip is connected to the heat transfer plate. The second chip is located on a side that is of the heat transfer plate and that faces away from the circuit board, and the second chip is connected to the heat transfer plate. The chip structure may be used in the electronic assembly, and the electronic assembly may be used in the electronic device.

## Description

This application claims priority to Chinese Patent Application No. 202410099181.1, filed with the China National Intellectual Property Administration on January 23, 2024 and entitled "ELECTRONIC ASSEMBLY, ELECTRONIC DEVICE, AND CHIP STRUCTURE", which is incorporated herein by reference in its entirety.

### TECHNICAL FIELD

Embodiments of this application relate to the field of packaging technologies, and in particular, to an electronic assembly, an electronic device, and a chip structure.

### BACKGROUND

Package on package (Package on package, POP) is an integrated circuit packaging method usually used to combine a system on chip (system on chip, SOC) and a memory chip that are vertically discrete. For example, two or more chips are mounted atop each other, that is, stacked, to form a POP packaged component. In this case, signal interconnection may be provided between chips through a standard interface (standard interface), which has advantages of high bandwidth and a short signal transmission path. The POP packaged component is usually used in electronic devices such as a mobile phone, a personal digital assistant (personal digital assistant, PDA), and a digital camera, to achieve a higher-density component layout. However, as performance of the electronic devices improves generation by generation, thermal power consumption of chips also increases. Therefore, a challenge brought by heat dissipation of the POP packaged component becomes increasingly prominent.

### SUMMARY

This application provides an electronic assembly, an electronic device, and a chip structure, to enhance a heat dissipation capability of the electronic assembly.

According to one aspect, an electronic assembly is provided, including: a circuit board, a first chip, a second chip, and a heat transfer plate. The heat transfer plate is located on a side of the circuit board. The first chip is located between the heat transfer plate and the circuit board, the first chip is connected to the circuit board, and the first chip is connected to the heat transfer plate. The second chip is located on a side that is of the heat transfer plate and that faces away from the circuit board, and the second chip is connected to the heat transfer plate.

In the electronic assembly provided in this embodiment of this application, because the heat transfer plate is disposed between the first chip and the second chip, heat of the first chip and heat of the second chip may be separately conducted outward through the heat transfer plate, for example, may be conducted outward to an external heat dissipation structure. The external heat dissipation structure herein may be, for example, an air-cooled heat dissipator, a liquid cooling plate, or a vapor chamber (Vapor Chamber, VC). In this way, a problem of large thermal resistance in a heat dissipation path of the first chip that is caused because heat of the first chip needs to pass the second chip upward before dissipation is resolved, and/or a problem of large thermal resistance in a heat dissipation path of the second chip that is caused because heat of the second chip needs to pass the first chip downward before dissipation is resolved. Therefore, the electronic assembly provided in this embodiment of this application has an advantage of high heat dissipation efficiency of the first chip and the second chip, and is applicable to a use scenario with higher thermal power consumption, so that performance of an electronic device using the electronic assembly is improved.

In some embodiments, a surface of a side that is of the first chip and that is close to the heat transfer plate includes a plurality of first contacts. The electronic assembly further includes a plurality of first solder balls located between the heat transfer plate and the first chip. The heat transfer plate is connected to the plurality of first contacts through the plurality of first solder balls.

For example, the plurality of first solder balls between the heat transfer plate and the first chip may all be configured to transmit an electrical signal (for example, configured to transmit a data signal, a control signal, or the like required in a working process of the first chip).

For example, at least one first solder ball may not be configured to transmit an electrical signal (for example, not be configured to transmit the data signal, the control signal, or the like required in the working process of the first chip), but is configured to increase heat transfer and reliability, so as to improve heat transfer efficiency between the first chip and the heat transfer plate. In this case, gaps between the plurality of first solder balls may be further filled with underfill, to further improve heat transfer efficiency between the first chip and the heat transfer plate.

For example, for a first contact connected to the first solder ball not configured to transmit an electrical signal, a signal line connected to the first contact may not be disposed in the first chip.

For example, for a contact, on the heat transfer plate, connected to the first solder ball not configured to transmit an electrical signal, a signal line connected to the contact may either not be disposed in the heat transfer plate.

In some embodiments, a surface of a side that is of the second chip and that is close to the heat transfer plate includes a plurality of second contacts. The electronic assembly further includes a plurality of second solder balls located between the heat transfer plate and the second chip. The heat transfer plate is connected to the plurality of second contacts through the plurality of second solder balls.

For example, the plurality of second solder balls between the heat transfer plate and the second chip may all be configured to transmit an electrical signal (for example, configured to transmit a data signal, a control signal, or the like required in a working process of the second chip).

For example, at least one second solder ball may not be configured to transmit an electrical signal (for example, not be configured to transmit the data signal, the control signal, or the like required in the working process of the second chip), but is configured to increase heat transfer and reliability, so as to improve heat transfer efficiency between the second chip and the heat transfer plate. In this case, a gap between second solder balls may be further filled with underfill, to further improve heat transfer efficiency between the second chip and the heat transfer plate.

For example, for a second contact connected to the second solder ball not configured to transmit an electrical signal, a signal line connected to the second contact may not be disposed in the second chip.

For example, for a contact, on the heat transfer plate, connected to the second solder ball not configured to transmit an electrical signal, a signal line connected to the contact may either not be disposed in the heat transfer plate.

In some embodiments, the electronic assembly further includes underfill filled between the heat transfer plate and the first chip. In this embodiment, heat transfer efficiency between the first chip and the heat transfer plate can be further improved.

In some embodiments, the electronic assembly further includes underfill filled between the heat transfer plate and the second chip. In this embodiment, heat transfer efficiency between the second chip and the heat transfer plate can be further improved.

In some embodiments, the first chip includes a first die and a first protection portion. The heat transfer plate is stacked on a side that is of the first die and that faces away from the circuit board. A surface that is of the heat transfer plate and that faces away from the circuit board includes a heat dissipation surface and a plurality of third contacts. The heat dissipation surface is electrically insulated from the plurality of third contacts. The first protection portion surrounds the first die and the heat transfer plate. The first protection portion exposes the heat dissipation surface and the third contacts. The plurality of third contacts are connected to the second chip. In this way, heat in the first chip is more likely to be conducted out of the heat dissipation surface of the heat transfer plate, so that heat dissipation effect of the first chip is improved.

In some embodiments, the first protection portion includes a first packaging substrate and a first plastic packaging portion. A surface that is of the first die and that faces away from the heat transfer plate is connected to the first packaging substrate. The first plastic packaging portion is connected to the first packaging substrate and at least surrounds a side surface of the first die and all or a part of a surface that is of the heat transfer plate and that is close to the first die. The first chip further includes a heat-conducting portion. The heat-conducting portion is located in the first plastic packaging portion, and the heat-conducting portion is connected to the first packaging substrate and the heat transfer plate. In this embodiment, the heat-conducting portion is disposed to connect the first packaging substrate and the heat transfer plate, so that heat in the first chip is more likely to be transferred to the heat transfer plate, to be conducted to a first heat-conducting structure and a first heat-dissipation heat sink through the heat dissipation surface of the heat transfer plate. In this way, heat dissipation efficiency is improved.

In some embodiments, the first chip further includes a connection plate. The connection plate is stacked between the first die and the heat transfer plate, and the connection plate is in contact with both the first die and the heat transfer plate. In this embodiment, the connection plate is added, so that heat of the first die can be better conducted to the heat transfer plate with higher heat transfer efficiency, to be conducted to the first heat-conducting structure and the first heat-dissipation heat sink through the heat dissipation surface of the heat transfer plate. In this way, heat dissipation efficiency is improved.

In some embodiments, a surface that is of the heat transfer plate and that faces away from the circuit board includes a heat dissipation surface and a plurality of third contacts. The heat dissipation surface is electrically insulated from the plurality of third contacts, and the plurality of third contacts are connected to the second chip. In this embodiment, the third contact may be configured for both heat conduction and signal conduction. The heat dissipation surface may be configured to conduct heat to the external heat dissipation structure. For example, the heat dissipation surface includes a metal surface, and the metal surface has high heat dissipation efficiency.

In some embodiments, the plurality of third contacts form at least one third contact group. The heat dissipation surface includes a first heat dissipation surface, and the first heat dissipation surface is disposed around at least one side of the third contact group. The one third contact group herein may be configured to electrically connect to one second chip. In this case, the heat dissipation surface includes a first heat dissipation surface, and the first heat dissipation surface is disposed around at least one side of the third contact group. For example, for a rectangular third contact group, the first heat dissipation surface may be disposed around one side, two sides, three sides, or four sides of the third contact group.

In some embodiments, an area of the first heat dissipation surface is greater than an area of each third contact. This helps improve heat dissipation efficiency of the first heat dissipation surface.

In some embodiments, the heat dissipation surface further includes a second heat dissipation surface. A heat transfer portion that adapts to the second heat dissipation surface is specially disposed inside the heat transfer plate. In this way, thermal resistance on a transfer path can be effectively reduced. The thermal resistance means that heat transferred from the first chip is transferred to the heat dissipation surface through the heat transfer portion inside the heat transfer plate, to be transferred to the first heat-dissipation heat sink through the first heat-conducting structure outside the heat transfer plate, so that heat dissipation efficiency is improved. For example, a via may be punched inside a PCB board to fill a material (namely, the heat transfer portion), for example, metal copper, with a higher heat conductivity coefficient than that of an insulation medium layer, so that heat dissipation efficiency is improved.

In some embodiments, the heat dissipation surface includes the metal surface. This helps improve heat transfer efficiency of the heat transfer plate. In some embodiments, the electronic assembly further includes the first heat-dissipation heat sink and the first heat-conducting structure. The first heat-dissipation heat sink is located on a side that is of the second chip and that faces away from the heat transfer plate. The first heat-conducting structure is connected to the heat dissipation surface of the heat transfer plate and the first heat-dissipation heat sink. The first heat-dissipation heat sink may be an air-cooled heat dissipator, a liquid cooling plate, a vapor chamber, or the like, and the first heat-dissipation heat sink may be directly configured to dissipate heat for the second chip. In this embodiment, because the first heat-conducting structure is further set to connect to the heat dissipation surface (for example, the first heat dissipation surface) of the heat transfer plate and the first heat-dissipation heat sink, heat of the first chip may be transferred to the first heat-dissipation heat sink through the heat transfer plate and the second chip (where thermal resistance on this path is large), and may be further transferred to the first heat-dissipation heat sink through the heat transfer plate and the first heat-conducting structure (where thermal resistance on this path is small), so that heat dissipation efficiency is greatly improved. In some embodiments, the first heat-conducting structure includes at least one of metal, an alloy, graphite, pure silicon, diamond copper, and an electronic component. The metal includes but is not limited to one of elements such as copper, silver, and aluminum. The alloy includes but is not limited to a combination of a plurality of elements such as copper, silver, and aluminum. Metal, alloy, graphite, and pure silicon all have high heat transfer efficiency. Diamond copper may also be referred to as diamond copper, is a composite material of metal copper and diamond, and has higher heat transfer efficiency than copper. In addition, it should be noted that the electronic component may be a component having a function, such as a capacitor, an inductor, or a resistor. When the first heat-conducting structure includes the electronic component, the first heat-conducting structure has a heat transfer function and can further meet some electrical functional requirements, which has higher practicability.

In some embodiments, the first heat-conducting structure is soldered to the heat dissipation surface of the heat transfer plate, or a thermal interface material (thermal interface material, TIM) is added between the first heat-conducting structure and the heat dissipation surface of the heat transfer plate. For example, the first heat-conducting structure may be soldered to the first heat dissipation surface of the heat transfer plate. In this way, thermal resistance between the first heat-conducting structure and the heat transfer plate can be reduced, and heat transfer efficiency can be improved.

In some embodiments, a thermal interface material is filled between the first heat-dissipation heat sink and the first heat-conducting structure. The thermal interface material has features of bridging a contact interface micro-gap and reducing interfacial thermal contact resistance, so that heat transfer efficiency between the first heat-conducting structure and the first heat-dissipation heat sink can be increased, and heat dissipation effect of the first chip can be improved.

The first heat-dissipation heat sink and the first heat-conducting structure may be of an integrated structure. In this way, thermal contact resistance can be further reduced, and thermal resistance on a heat transfer path (thermal resistance between the first chip and the first heat-dissipation heat sink) can be reduced.

In some embodiments, the heat transfer plate and the first heat-conducting structure may be of an integrated structure. In this way, thermal contact resistance between the first heat-conducting structure and the heat transfer plate can be reduced, and the thermal resistance on the heat transfer path (the thermal resistance between the first chip and the first heat-dissipation heat sink) can be reduced. The heat transfer portion that adapts to the second heat dissipation surface may be specially disposed inside the heat transfer plate. In this way, the thermal resistance on the transfer path can be effectively reduced. The thermal resistance means that heat transferred from the first chip is transferred to the second heat dissipation surface through the heat transfer portion inside the heat transfer plate, to be transferred to the first heat-dissipation heat sink through the first heat-conducting structure outside the heat transfer plate, so that heat dissipation efficiency is improved. For example, the via may be punched inside the PCB board, especially in a position corresponding to the first heat-conducting structure, to fill the material (namely, the heat transfer portion), for example, metal copper, with a higher heat conductivity coefficient than that of the insulation medium layer, so that heat dissipation efficiency is improved. For example, the PCB board is used as an example. The "integrated structure" herein may be as follows: After the thick PCB board is formed, another position other than a region of the first heat-conducting structure is milled thin, to form the heat transfer plate and the first heat-conducting structure that are integrated. In this case, the first heat-conducting structure may include both a conductive column and an insulation material around the conductive column.

In some embodiments, a thermal interface material (thermal interface material, TIM) is filled between the first heat-dissipation heat sink and the second chip. The thermal interface material has features of bridging a contact interface micro-gap and reducing interfacial thermal contact resistance, so that heat transfer efficiency between the second chip and the first heat-dissipation heat sink can be increased, and heat dissipation effect of the second chip can be improved.

In some embodiments, the first heat-conducting structure is located between the heat transfer plate and the first heat-dissipation heat sink, and the first heat-conducting structure is located on at least one side of the second chip. In this embodiment, the first heat-conducting structure may be located on one or more sides of the second chip. For example, when the second chip is rectangular, the first heat-conducting structure may be arranged around the second chip.

In some embodiments, the first heat-conducting structure includes a first heat-conducting portion. The first heat-conducting portion extends in a first direction, and the first direction is parallel to a plane on which the heat transfer plate is located. There are a plurality of second chips. The plurality of second chips are arranged in the first direction, and the plurality of second chips are located on a same side of the first heat-conducting portion.

On the basis of the foregoing embodiments, the first heat-conducting structure may further include a second heat-conducting portion, and the second heat-conducting portion extends in the first direction. In a second direction, the plurality of second chips are located between the first heat-conducting portion and the second heat-conducting portion, and the second direction intersects with the first direction.

In some embodiments, there are a plurality of second chips, and the first heat-conducting structure is located between at least two of the second chips.

On the basis of the foregoing embodiments, the heat transfer plate further includes an opening. The first heat-conducting structure passes through the opening and is connected to the first chip. In this example, the first heat-conducting structure may be directly connected to the first chip. This helps further reduce the thermal resistance between the first chip and the first heat-dissipation heat sink, and improve heat dissipation efficiency. At least one first heat-conducting structure is added between the heat transfer plate and the circuit board, to improve reliability of the electronic assembly, and further improve thermal interaction features of the heat transfer plate and the circuit board, so that heat dissipation is enhanced. A support structure is not limited to metal, a non-metal material, or a functional component, and connection between the support structure and the heat transfer plate is not limited to adhesive bonding, soldering, and direct physical contact. Connection between the first heat-conducting structure and the circuit board is not limited to adhesive bonding, soldering, and direct physical contact.

In some embodiments, a thermal interface material is filled between the first heat-conducting structure and the first chip. The thermal interface material has a feature of reducing interfacial thermal contact resistance, so that heat transfer efficiency between the first chip and the first heat-conducting structure can be increased, and heat dissipation effect of the first chip can be improved.

In some embodiments, the heat transfer plate includes a first contact surface and a second contact surface. The first contact surface is an inner wall surface of the opening. The second contact surface is located on a side that is of the heat transfer plate and that faces away from the first chip, and the second contact surface surrounds the opening. The first heat-conducting structure is connected to at least one of the first contact surface and the second contact surface. In this embodiment, when the first heat-conducting structure is connected to the first contact surface and/or the second contact surface, the thermal resistance between the first heat-conducting structure and the heat transfer plate can be reduced, and heat transfer efficiency can be improved.

In some embodiments, the electronic assembly further includes the support structure located between the heat transfer plate and the circuit board and connected to both the heat transfer plate and the circuit board. In this embodiment, the support structure may be used to support the heat transfer plate and improve reliability of the electronic assembly. The support structure herein is not limited to metal, a non-metal material, a functional component, or the like. Connection between the support structure and the heat transfer plate is not limited to adhesive bonding, soldering, and direct physical contact. Connection between the support structure and the circuit board is not limited to adhesive bonding, soldering, and direct physical contact.

In some embodiments, the support structure is configured as a second heat-conducting structure. In this way, the thermal interaction features of both the heat transfer plate and the circuit board can be improved, so that heat dissipation is enhanced.

In some embodiments, the support structure is disposed around the first chip. In this way, effect of supporting the heat transfer plate by the support structure can be improved, and stability and reliability are high.

In some embodiments, the heat transfer plate and the second heat-conducting structure may be of an integrated structure. In this way, thermal contact resistance between the second heat-conducting structure and the heat transfer plate can be reduced, and thermal resistance on a heat transfer path (thermal resistance between the first chip and the second heat-conducting structure) can be reduced. A heat transfer portion that adapts to a heat dissipation surface in contact with the second heat-conducting structure is specially disposed inside the heat transfer plate. In this way, the thermal resistance on the transfer path can be effectively reduced. The thermal resistance means that heat transferred from the first chip is transferred to the heat dissipation surface through the heat transfer portion inside the heat transfer plate, to be transferred to the circuit board or another heat dissipation structure through the second heat-conducting structure outside the heat transfer plate, so that heat dissipation efficiency is improved. For example, a via may be punched inside the PCB board, especially in the position corresponding to the first heat-conducting structure, to fill a material (namely, the heat transfer portion), for example, metal copper, with a higher heat conductivity coefficient than that of the insulation medium layer, so that heat dissipation efficiency is improved. For example, the PCB board is used as an example. The "integrated structure" herein may be as follows: After the thick PCB board is formed, another position other than a region of the second heat-conducting structure is milled thin, to form the heat transfer plate and the second heat-conducting structure that are integrated. In this case, the second heat-conducting structure may include both a conductive column and an insulation material around the conductive column.

In some embodiments, the electronic assembly further includes a third heat-conducting structure and a second heat-dissipation heat sink. The second heat-dissipation heat sink is located on a side that is of the circuit board and that faces away from the heat transfer plate. The third heat-conducting structure is located between the heat transfer plate and the second heat-dissipation heat sink. The third heat-conducting structure passes through an opening in the circuit board. One end of the third heat-conducting structure is connected to the heat transfer plate, and the other end of the third heat-conducting structure is connected to the second heat-dissipation heat sink. In this embodiment, the third heat-conducting structure may pass through the circuit board, and directly implement thermal connection to the second heat-dissipation heat sink on the side that is of the circuit board and that faces away from the first chip, so that efficient heat transfer from the heat transfer plate to the second heat-dissipation heat sink on the side that is of the circuit board and that faces away from the first chip is implemented, to achieve heat dissipation effect. The third heat-conducting structure herein is not limited to metal, non-metal, an alloy, or the like.

In some embodiments, the third heat-conducting structure is disposed around the first chip. Herein, the third heat-conducting structure can further well support the heat transfer plate.

In some embodiments, the third heat-conducting structure implements thermal connection to the heat transfer plate through soldering or a thermal interface material. In this way, the heat transfer plate and the third heat-conducting structure have high heat transfer efficiency. A side that is of the heat transfer plate and that is close to the third heat-conducting structure includes a third heat dissipation surface, and a heat transfer portion that adapts to the third heat dissipation surface is specially disposed inside the heat transfer plate. In this way, thermal resistance on a transfer path can be effectively reduced. The thermal resistance means that heat transferred from the first chip is transferred to the heat dissipation surface through the heat transfer portion inside the heat transfer plate, to be transferred to the first heat-dissipation heat sink through the first heat-conducting structure outside the heat transfer plate, so that heat dissipation efficiency is improved. For example, a via may be punched inside the PCB board to fill a material (namely, the heat transfer portion), for example, metal copper, with a higher heat conductivity coefficient than that of the insulation medium layer, so that heat dissipation efficiency is improved.

In some embodiments, the third heat-conducting structure is connected to the second heat-dissipation heat sink through soldering or a thermal interface material. In this way, the third heat-conducting structure and the second heat-dissipation heat sink have high heat transfer efficiency.

In some embodiments, the third heat-conducting structure and the second heat-dissipation heat sink are of an integrated structure. In this way, the third heat-conducting structure and the second heat-dissipation heat sink have higher heat transfer efficiency.

In some embodiments, the heat transfer plate and the third heat-conducting structure may be of an integrated structure. In this way, thermal contact resistance between the third heat-conducting structure and the heat transfer plate can be reduced, and thermal resistance on the heat transfer path (the thermal resistance between the first chip and the first heat-dissipation heat sink) can be reduced. A heat transfer portion that adapts to a heat dissipation surface in contact with the third heat-conducting structure is specially disposed inside the heat transfer plate. In this way, the thermal resistance on the transfer path can be effectively reduced. The thermal resistance means that heat transferred from the first chip is transferred to the heat dissipation surface through the heat transfer portion inside the heat transfer plate, to be transferred to the first heat-dissipation heat sink through the first heat-conducting structure outside the heat transfer plate, so that heat dissipation efficiency is improved. For example, a via may be punched inside the PCB board, especially in the position corresponding to the first heat-conducting structure, to fill a material (namely, the heat transfer portion), for example, metal copper, with a higher heat conductivity coefficient than that of the insulation medium layer, so that heat dissipation efficiency is improved. For example, the PCB board is used as an example. The "integrated structure" herein may be as follows: After the thick PCB board is formed, another position other than a region of the third heat-conducting structure is milled thin, to form the heat transfer plate and the third heat-conducting structure that are integrated. In this case, the third heat-conducting structure may include both a conductive column and an insulation material around the conductive column.

According to another aspect, a chip structure is provided, including a first die, a heat transfer plate, and a first protection portion. The heat transfer plate is stacked on a side of the first die. A surface that is of the heat transfer plate and that faces away from the first die includes a heat dissipation surface and a plurality of third contacts. The heat dissipation surface is electrically insulated from the plurality of third contacts. The first protection portion surrounds the first die and all or a part of a surface that is of the heat transfer plate and that is close to the first die (for example, the first protection portion is larger, smaller, or equal in size relative to the heat transfer plate in a direction parallel to a circuit board, or is large or smaller in size relative to the heat spreader in a direction, which is not limited herein), and the first protection portion exposes the heat dissipation surface and the third contacts. In this way, heat in the first chip is more likely to be conducted out of the heat dissipation surface of the heat transfer plate, so that heat dissipation effect of the first chip is improved.

In some embodiments, the first protection portion includes a first packaging substrate and a first plastic packaging portion. A surface that is of the first die and that faces away from the heat transfer plate is connected to the first packaging substrate, and the first plastic packaging portion is connected to the first packaging substrate and at least surrounds a side surface of the first die and all or a part of the surface that is of the heat transfer plate and that is close to the first die. The first chip further includes a heat-conducting portion. The heat-conducting portion is located in the first plastic packaging portion, and the heat-conducting portion is connected to the first packaging substrate and the heat transfer plate. In this embodiment, the heat-conducting portion is disposed to connect the first packaging substrate and the heat transfer plate, so that heat in the first chip is more likely to be transferred to the heat transfer plate. In this way, heat dissipation efficiency is improved. There may be one or more heat-conducting portions herein, and it is not limited to that a part or all of the heat-conducting portions have functions of transmitting a signal and transmitting heat.

In some embodiments, the first chip further includes a connection plate. The connection plate is stacked between the first die and the heat transfer plate, and the connection plate is connected to both the first die and the heat transfer plate. In this embodiment, the connection plate is added, so that heat of the first die can be better conducted to the heat transfer plate with higher heat transfer efficiency, which is more conducive to reducing a junction temperature of the first chip.

In some embodiments, the first die in the first chip is directly connected to the heat transfer plate. In this embodiment, heat of the first die can be better conducted to the heat transfer plate with higher heat transfer efficiency, which is more conducive to reducing the junction temperature of the first chip.

On the basis of some of the foregoing embodiments, connection between the first die and the heat transfer plate, between the first die and the connection plate, and between the connection plate and the heat transfer plate may be fixed to a specific relative structure through underfill, soldering, soldering spots, or a plastic packaging portion, so that heat is better transferred from the first die to the heat transfer plate.

In some embodiments, for the chip structure, refer to the foregoing embodiments. At least one of a first heat-conducting structure, a second heat-conducting structure, and a third heat-conducting structure is disposed on the chip structure. On this basis, for example, the heat transfer plate and at least one of the first heat-conducting structure, the second heat-conducting structure, and the third heat-conducting structure may be manufactured into an integrated structure (refer to the foregoing descriptions, and details are not described herein again), to further reduce thermal resistance and improve heat transfer performance.

According to still another aspect, an electronic device is provided, including a housing, where the electronic assembly described in any one of the foregoing embodiments is located in the housing. The electronic device provided in this embodiment includes the electronic assembly in any one of the foregoing embodiments, and therefore has beneficial effects of the electronic assembly in any one of the foregoing embodiments, which are not described herein again.

### BRIEF DESCRIPTION OF DRAWINGS

FIG. 1 is a diagram of a structure of an electronic device according to an embodiment of this application;
FIG. 2 is a diagram of a structure of an electronic assembly according to an embodiment of this application;
FIG. 3 is a top view of a heat transfer plate according to an embodiment of this application;
FIG. 4 is a top view of a position relationship between a heat transfer plate, a second chip, and a first heat-conducting structure in FIG. 2;
FIG. 5 is another top view of a position relationship between a heat transfer plate, a second chip, and a first heat-conducting structure in FIG. 2;
FIG. 6 is a diagram of a structure of another electronic assembly according to an embodiment of this application;
FIG. 7 is a diagram of a structure of still another electronic assembly according to an embodiment of this application;
FIG. 8 is a top view of a position relationship between a heat transfer plate, a second chip, and a first heat-conducting structure in FIG. 6 or FIG. 7;
FIG. 9 is a diagram of a structure of still another electronic assembly according to an embodiment of this application;
FIG. 10 is a diagram of a structure of still another electronic assembly according to an embodiment of this application;
FIG. 11 is a diagram of a structure of still another electronic assembly according to an embodiment of this application;
FIG. 12 is a top view of a position relationship between a first chip, a second chip, and a first heat-conducting structure in FIG. 9, FIG. 10, or FIG. 11;
FIG. 13 is a diagram of a structure of still another electronic assembly according to an embodiment of this application;
FIG. 14 is a top view of a position relationship between a first chip, a second chip, and a first heat-conducting structure in FIG. 13;
FIG. 15 is a diagram of a structure of still another electronic assembly according to an embodiment of this application; and
FIG. 16 is a diagram of a structure of still another electronic assembly according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second" mentioned below are merely intended for ease of description, and shall not be understood as an indication or implication of relative importance or implicit indication of a quantity of indicated technical features. Therefore, a feature defined by "first", "second", or the like may explicitly or implicitly include one or more features. In the descriptions of this application, unless otherwise stated, "a plurality of" means two or more than two.

In embodiments of this application, unless otherwise specified and limited, the term "connection" may be direct mechanical connection or electrical connection, or may be indirect mechanical connection or electrical connection through an intermediate medium. The mechanical connection herein may not be limited to being used to transmit an electrical signal, and the electrical connection is used to transmit an electrical signal.

In embodiments of this application, "thermal connection" or "heat transfer connection" means any connection manner that can be used to implement heat transfer, for example, direct mechanical connection or indirect mechanical connection through an intermediate medium (for example, a thermal interface material).

In embodiments of this application, "soldering" includes any soldering manner, for example, a soldering manner based on ball grid array (BALL GRID ARRAY, BGA) packaging or land grid array (LAND GRID ARRAY, LGA) packaging, or a soldering manner through adding of full-surface solder.

In embodiments of this application, the word such as "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word such as "example" or "for example" is intended to present a relative concept in a specific manner.

In embodiments of this application, "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between the associated objects.

In embodiments of this application, for example, on, under, left, right, front, and rear are relative direction indications used to explain structures and movement of different parts in this application. These indications are appropriate when the parts are in positions shown in the figure. However, if descriptions of the positions of the parts change, these direction indications correspondingly change.

An embodiment of this application provides an electronic device. The electronic device may be a mobile phone, a tablet computer (tablet personal computer), a laptop computer (laptop computer), a personal digital assistant (personal digital assistant, PDA), a digital camera, a personal computer, a notebook computer, a smartwatch, a vehicle-mounted device, a wearable device, augmented reality (augmented reality, AR) glasses, an AR helmet, virtual reality (virtual reality, VR) glasses, a VR helmet, a server, a switch, a network bridge (also referred to as a bridge), a repeater, a router, a gateway (also referred to as a protocol converter), or the like. It may be understood that a specific form of the electronic device 1000 is not specially limited in embodiments of this application.

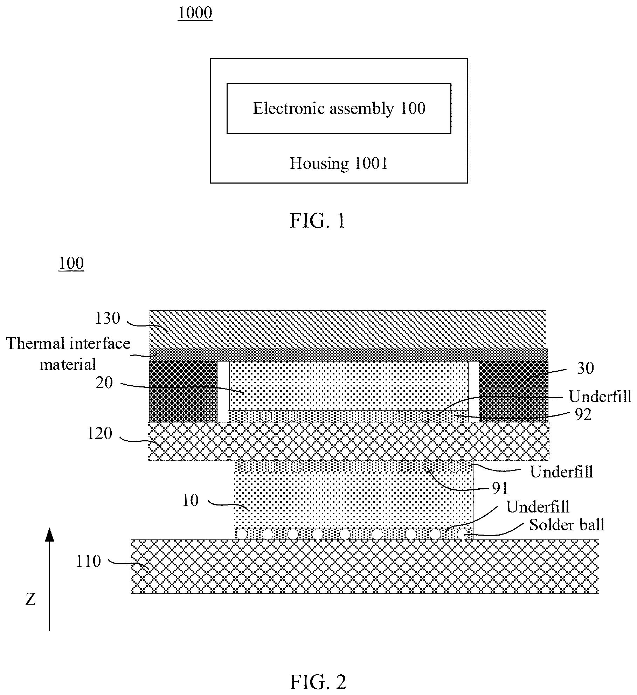

FIG. 1 is a diagram of a structure of an electronic device 1000 according to an embodiment of this application. As shown in FIG. 1, the electronic device 1000 may include a housing 1001 and an electronic assembly 100. Herein, a specific shape and a specific material of the housing 1001 are not limited. In other words, for different types of electronic devices 1000, housings 1001 with different shapes and different materials may be used according to requirements of the electronic devices 1000. The electronic assembly 100 is located in the housing 1001. For example, the electronic assembly 100 may be connected to an inner wall structure of the housing 1001. A connection manner herein includes but is not limited to at least one of clamping, screw connection, bonding, and the like. The electronic assembly 100 herein may also be referred to as a POP packaged component.

FIG. 2 is a diagram of a structure of an electronic assembly 100 according to an embodiment of this application. As shown in FIG. 2, the electronic assembly 100 includes a circuit board 110, a first chip 10, a second chip 20, and a heat transfer plate 120.

The circuit board 110 may be a printed circuit board (printed circuit board, PCB). The circuit board 110 may be a mainboard of an electronic device 1000. In some examples, the circuit board 110 includes a conducting layer and an insulation layer that are stacked. A front side and/or a rear side of the circuit board 110 may be configured to connect to a chip or another electronic component, such as a capacitor, a resistor, or an inductor.

The heat transfer plate 120 is located on a side of the circuit board 110. For example, in a thickness direction Z of the circuit board 110, the heat transfer plate 120 and the circuit board 110 may be disposed face to face. Face-to-face disposing may be understood as that in the thickness direction Z, an orthographic projection of the heat transfer plate 120 overlaps with an orthographic projection of the circuit board 110.

The first chip 10 is located between the heat transfer plate 120 and the circuit board 110, the first chip 10 is connected to the circuit board 110, and the first chip 10 is connected to the heat transfer plate 120. In some examples, the first chip 10 may be a system on chip (system on chip, SOC). For example, the first chip 10 and the circuit board 110 may be connected in a ball grid array (Ball Grid Array, BGA) packaging manner or a land grid array (Land Grid Array, LGA) packaging manner. In the BGA packaging manner, a solder ball (Solder ball) is mainly used for connection; and in the LGA packaging manner, a soldering spot is mainly used for connection. The soldering spot herein is flat, and a size of the soldering spot is smaller than a size of the solder ball. On this basis, a remaining gap between the first chip 10 and the circuit board 110 may be further filled with underfill (Underfill). A material of the underfill includes but is not limited to silicone. In this way, the first chip 10 and the circuit board 110 may transmit an electrical signal to each other.

Connection manners between the first chip 10 and the heat transfer plate 120 may, for example, all be electrical connection that can be used to transmit an electrical signal, or may partially be electrical connection used to transmit an electrical signal, and partially be heat transfer connection not used to transmit an electrical signal. In this embodiment, for example, connection between the heat transfer plate 120 and the first chip 10 is partially electrical connection used to transmit an electrical signal and partially heat transfer connection not used to transmit an electrical signal. For example, the BGA packaging manner or the LGA packaging manner may also be used between the first chip 10 and the heat transfer plate 120, and underfill is filled between the first chip 10 and the heat transfer plate 120, to further improve heat transfer efficiency between the first chip 10 and the heat transfer plate 120.

The second chip 20 is located on a side that is of the heat transfer plate 120 and that faces away from the circuit board 110, and the second chip 20 is connected to the heat transfer plate 120. In some examples, the second chip 20 may be a double data rate synchronous dynamic random access memory (double data rate synchronous dynamic random access memory, DDR SDRAM). For example, the BGA packaging manner or the LGA packaging manner may also be used between the second chip 20 and the heat transfer plate 120, and underfill is also filled between the second chip 20 and the heat transfer plate 120, to further improve heat transfer efficiency between the second chip 20 and the heat transfer plate 120. In addition, connection between the heat transfer plate 120 and the second chip 20 may all be electrical connection that can be used to transmit an electrical signal, or may partially be electrical connection used to transmit an electrical signal, and partially be heat transfer connection not used to transmit an electrical signal. This is not limited in this application. In this embodiment of this application, for example, connection between the heat transfer plate 120 and the second chip 20 is partially electrical connection used to transmit an electrical signal and partially heat transfer connection not used to transmit an electrical signal. In this way, the second chip 20 may be electrically connected to the first chip 10 through the heat transfer plate 120, and an electrical signal may be transmitted between the first chip 10 and the second chip 20 through the heat transfer plate 120, without disposing a redundant outer lead to connect the first chip 10 and the second chip 20. In addition, the heat transfer plate 120 has functions of both heat conduction and signal conduction.

Types of the first chip 10 and the second chip 20 may be the same, or may be different. In addition to the foregoing examples, the first chip 10 and the second chip 20 may alternatively be other chips, for example, central processing units (central processing units, CPUs), graphics processing units (graphics processing units, GPUs), or double data rate synchronous dynamic random access memories. The types of the first chip 10 and the second chip 20 are not further limited in embodiments of this application.

In the electronic assembly 100 provided in this embodiment of this application, because the heat transfer plate 120 is disposed between the first chip 10 and the second chip 20, heat of the first chip 10 and heat of the second chip 20 may be separately conducted outward through the heat transfer plate 120, for example, may be conducted outward to an external heat dissipation structure. The external heat dissipation structure herein may be, for example, an air-cooled heat dissipator, a liquid cooling plate, or a vapor chamber. In this way, a problem of large thermal resistance in a heat dissipation path of the first chip 10 that is caused because heat of the first chip 10 needs to pass the second chip 20 upward before dissipation is resolved, and/or a problem of large thermal resistance in a heat dissipation path of the second chip 20 that is caused because heat of the second chip 20 needs to pass the first chip 10 downward before dissipation is resolved. Therefore, in the electronic assembly 100 provided in this embodiment of this application, the first chip 10 and the second chip 20 have high heat dissipation efficiency, and the electronic assembly 100 is applicable to a use scenario with higher thermal power consumption, so that performance of the electronic device 1000 using the electronic assembly 100 is improved.

A surface of a side that is of the first chip 10 and that is close to the heat transfer plate 120 may include a plurality of first contacts. For example, when the first chip 10 and the heat transfer plate 120 are connected in the BGA packaging manner, as shown in FIG. 2, the electronic assembly 100 may further include a plurality of first solder balls 91 located between the heat transfer plate 120 and the first chip 10, and the heat transfer plate 120 is connected to the plurality of first contacts through the plurality of first solder balls 91.

For example, the plurality of first solder balls 91 between the heat transfer plate 120 and the first chip 10 may all be configured to transmit an electrical signal, for example, configured to transmit a data signal, a control signal, or the like required in a working process of the first chip 10.

For example, at least one first solder ball 91 may not be configured to transmit an electrical signal, for example, not be configured to transmit the data signal, the control signal, or the like required in the working process of the first chip 10, but is configured to increase heat transfer and reliability, so as to improve heat transfer efficiency between the first chip 10 and the heat transfer plate 120. In this case, a gap between first solder balls 91 may be further filled with underfill, to further improve heat transfer efficiency between the first chip 10 and the heat transfer plate 120.

A surface of a side that is of the second chip 20 and that is close to the heat transfer plate 120 includes a plurality of second contacts. For example, when the second chip 20 and the heat transfer plate 120 are connected in the BGA packaging manner, as shown in FIG. 2, the electronic assembly 100 may further include a plurality of second solder balls 92 located between the heat transfer plate 120 and the second chip 20. The heat transfer plate 120 is connected to the plurality of second contacts through the plurality of second solder balls 92.

For example, the plurality of second solder balls 92 between the heat transfer plate 120 and the second chip 20 may all be configured to transmit an electrical signal, for example, configured to transmit a data signal, a control signal, or the like required in a working process of the second chip 20.

For example, at least one second solder ball 92 may not be configured to transmit an electrical signal, for example, not be configured to transmit the data signal, the control signal, or the like required in the working process of the second chip 20, but is configured to increase heat transfer and reliability, so as to improve heat transfer efficiency between the second chip 20 and the heat transfer plate 120. In this case, a gap between second solder balls 92 may be further filled with underfill, to further improve heat transfer efficiency between the second chip 20 and the heat transfer plate 120.

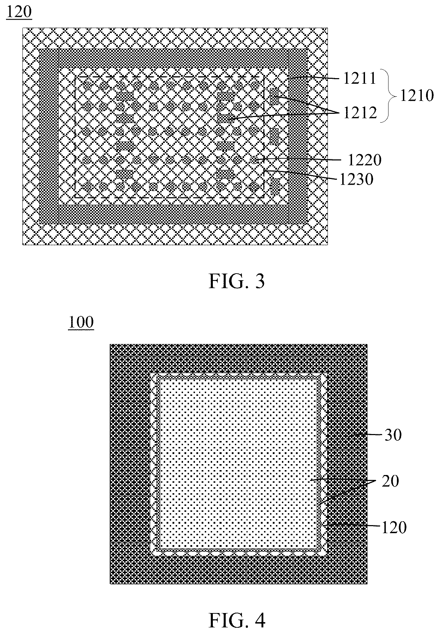

FIG. 3 is a top view of a heat transfer plate 120 according to an embodiment of this application. Refer to FIG. 3. In some embodiments, a surface that is of the heat transfer plate 120 and that faces away from the circuit board 110 includes a heat dissipation surface 1210 and a plurality of third contacts 1220. The heat dissipation surface 1210 is electrically insulated from the plurality of third contacts 1220, and the plurality of third contacts 1220 may be connected to the second chip through the plurality of second solder balls 92. In this embodiment, the third contact 1220 may be configured for both heat conduction and signal conduction. The heat dissipation surface 1210 may be configured to conduct heat to the external heat dissipation structure. For example, the heat dissipation surface 1210 includes a metal surface, and the metal surface has high heat dissipation efficiency.

There are a plurality of structural forms of the heat transfer plate 120 provided in this embodiment of this application, for example, including but not limited to the following two examples.

Example 1 of the heat transfer plate: The heat transfer plate 120 includes a PCB board, and the PCB board includes metal layers and an insulation layer that are stacked. The heat dissipation surface 1210 and the third contact 1220 may be metal surfaces, for example, copper surfaces, exposed at an opening of the insulation layer. A metal layer in which the heat dissipation surface is located may be separated from a metal layer in which the third contact is located through the insulation layer, to implement electrical insulation.

Example 2 of the heat transfer plate: The heat transfer plate 120 is a metal plate, for example, a copper plate. A hole is punched in the copper plate, an insulation side wall is provided on an inner wall of the hole, and then a conductive column is disposed in the insulation side wall, so that the third contact having a function of conducting an electrical signal may be formed. Another surface of the copper plate may be used as a heat dissipation surface, so that the heat transfer plate 120 can have higher heat transfer efficiency.

The plurality of third contacts 1220 may form at least one third contact group 1230 (in other words, all third contacts 1220 in a dashed-line box in FIG. 3 are one third contact group 1230). The one third contact group 1230 herein may be configured to electrically connect to one second chip 20. The heat dissipation surface 1210 may include a first heat dissipation surface 1211, and the first heat dissipation surface 1211 may be disposed on at least one side of the third contact group 1230. For example, for a rectangular third contact group 1230, the first heat dissipation surface 1211 may be disposed on one side, two sides, three sides, or four sides of the third contact group. An example in which the first heat dissipation surface 1211 is disposed all around the third contact group 1230 is used for illustration in FIG. 3.

For example, an area of the first heat dissipation surface 1211 is greater than an area of each third contact 1220. This helps improve heat dissipation efficiency of the first heat dissipation surface 1211.

For example, the heat dissipation surface 1210 may further include a second heat dissipation surface 1212. The heat transfer plate 120 may include a via, and the heat transfer plate 120 may further include a heat transfer portion disposed in the via. A surface that is of the heat transfer portion and that faces away from the circuit board 110 is the second heat dissipation surface 1212. For example, the via may be punched on a surface of the PCB board to fill the heat transfer portion, for example, metal copper, with higher heat transfer efficiency than that of the insulation layer, so that heat dissipation efficiency is improved. The heat transfer portion herein may be located around the third contact group 1230, or may be located between any two of the third contacts 1220. A magnitude relationship between an area of the second heat dissipation surface 1212 and the area of the third contact 1220 is not limited herein, and it needs to be ensured that electrical connection performance between the third contact 1220 and the second chip 20 is not affected.

In this embodiment of this application, the external heat dissipation structure may be disposed in a plurality of manners. For example, the external heat dissipation structure may be disposed independently of the electronic assembly 100, and is directly connected to the heat transfer plate 120, to quickly dissipate heat for the first chip 10 and the second chip 20 at the same time. For another example, the external heat dissipation structure may be integrated into a film layer of the circuit board 110, and then is connected to the heat transfer plate 120 through a connection portion. Because heat may not pass the first chip 10, thermal resistance of the second chip 20 can be reduced, to quickly dissipate heat for the first chip 10 and the second chip 20 at the same time. For another example, the external heat dissipation structure may be disposed on a side that is of the second chip 20 and that faces away from the first chip 10, and then is connected to the heat transfer plate 120 through a connection portion. Because heat may not pass the second chip 20, thermal resistance of the first chip 10 can be reduced, to quickly dissipate heat for the first chip 10 and the second chip 20 at the same time. The following provides an example of an external heat dissipation structure by using an example.

Refer to FIG. 2 and FIG. 3. In some embodiments, the external heat dissipation structure may include a first heat-dissipation heat sink 130 and a first heat-conducting structure 30. The first heat-dissipation heat sink 130 is located on a side that is of the second chip 20 and that faces away from the heat transfer plate 120. The first heat-conducting structure 30 is connected to the heat dissipation surface 1210 of the heat transfer plate 120 and the first heat-dissipation heat sink 130. The first heat-dissipation heat sink 130 may be an air-cooled heat dissipator, a liquid cooling plate, a vapor chamber, or the like, and the first heat-dissipation heat sink 130 may be directly configured to dissipate heat for the second chip 20. In this embodiment, because the first heat-conducting structure 30 is further set to connect to the heat dissipation surface 1210 (for example, the first heat dissipation surface 1211) of the heat transfer plate 120 and the first heat-dissipation heat sink 130, heat of the first chip 10 may be transferred to the first heat-dissipation heat sink 130 through the heat transfer plate 120 and the second chip 20 (where thermal resistance on this path is large), and may be further transferred to the first heat-dissipation heat sink 130 through the heat transfer plate 120 and the first heat-conducting structure 30 (where thermal resistance on this path is small), so that heat dissipation efficiency is greatly improved.

It should be noted that, in a case in which the heat transfer plate 120 and the first heat-conducting structure 30 are not disposed, when power consumption of the first chip 10 is high, a junction temperature of the first chip 10 is already excessively high before heat is transferred to the first heat-dissipation heat sink. Therefore, the first chip 10 is not applicable to a scenario with high power consumption. For example, power consumption of a first chip 10 of a specific type is 4 W. After a heat dissipation solution is determined, a temperature of the upper first heat-dissipation heat sink is about 35°C, and a junction temperature of the first chip 10 has exceeded 115°C. This indicates that thermal resistance (thermal resistance) between the top of the first chip 10 and the first heat-dissipation heat sink 130 is large. Further reducing the temperature of the first heat-dissipation heat sink 130 may further reduce the junction temperature of the first chip 10, but is not cost-effective. However, in this embodiment of this application, because the heat transfer plate 120 and the first heat-conducting structure 30 are disposed, heat of the first chip 10 can be quickly transferred to the first heat-dissipation heat sink 130, to reduce the junction temperature of the first chip 10, and greatly improve working performance of the first chip 10, so that the first chip 10 meets a use requirement of a scenario with higher power consumption.

For example, the first heat-conducting structure 30 may include at least one of metal, an alloy, graphite, pure silicon, diamond copper, and an electronic component. The metal includes but is not limited to one of elements such as copper, silver, and aluminum. The alloy includes but is not limited to a combination of a plurality of elements such as copper, silver, and aluminum. Metal, alloy, graphite, and pure silicon all have high heat transfer efficiency. Diamond copper may also be referred to as diamond copper, is a composite material of metal copper and diamond, and has higher heat transfer efficiency than copper. In addition, it should be noted that the electronic component may be a component having a function, such as a capacitor, an inductor, or a resistor. When the first heat-conducting structure 30 includes the electronic component, the first heat-conducting structure 30 has a heat transfer function and can further meet some electrical functional requirements, which has higher practicability.

In some embodiments, the first heat-conducting structure 30 may be soldered to the heat dissipation surface 1210 of the heat transfer plate 120. For example, the first heat-conducting structure 30 may be soldered to the first heat dissipation surface 1211 of the heat transfer plate 120. In this way, thermal resistance between the first heat-conducting structure 30 and the heat transfer plate 120 can be reduced, and heat transfer efficiency can be improved.

In some embodiments, the first heat-conducting structure 30 may further cover the second heat dissipation surface 1212 of the heat transfer plate 120. For example, the first heat-conducting structure 30 may be further soldered to the second heat dissipation surface 1212, to further improve heat transfer efficiency.

In some embodiments, a thermal interface material (thermal interface material, TIM) may be filled between the first heat-dissipation heat sink 130 and the first heat-conducting structure 30. The thermal interface material has features of bridging a contact interface micro-gap and reducing interfacial thermal contact resistance, so that heat transfer efficiency between the first heat-conducting structure 30 and the first heat-dissipation heat sink 130 can be increased, and heat dissipation effect of the first chip 10 can be improved.

In some embodiments, a thermal interface material (thermal interface material, TIM) may be filled between the first heat-dissipation heat sink 130 and the second chip 20. The thermal interface material has features of bridging a contact interface micro-gap and reducing interfacial thermal contact resistance, so that heat transfer efficiency between the second chip 20 and the first heat-dissipation heat sink 130 can be increased, and heat dissipation effect of the second chip can be improved.

For example, the thermal interface material between the first heat-dissipation heat sink 130 and the first heat-conducting structure 30 and the thermal interface material between the first heat-dissipation heat sink 130 and the second chip 20 may be of independent structures, or may be of an integrated structure.

FIG. 4 is a top view of a position relationship between the heat transfer plate 120, the second chip 20, and the first heat-conducting structure 30 in FIG. 2. As shown in FIG. 2, in some embodiments, the first heat-conducting structure 30 is located between the heat transfer plate 120 and the first heat-dissipation heat sink 130, and the first heat-conducting structure 30 is located on at least one side of the second chip 20. In this embodiment, the first heat-conducting structure 30 may be located on one or more sides of the second chip 20. For example, in an example in FIG. 4, when the second chip 20 is rectangular, the first heat-conducting structure 30 may be disposed all around the second chip 20.

In addition to the disposing manner of the first heat-conducting structure 30 in FIG. 4, the following several examples of the first heat-conducting structure 30 are further included. However, this is not limited thereto.

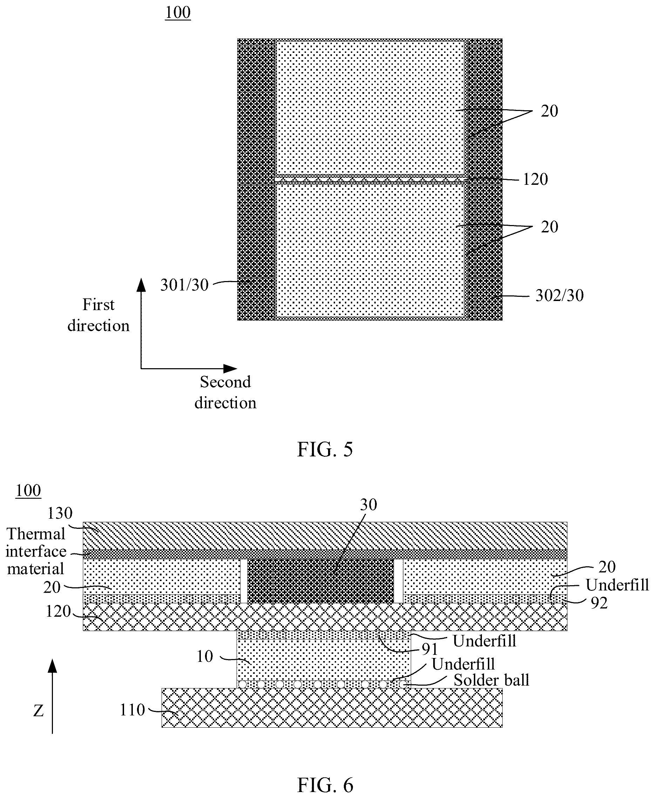

Example 1 of the first heat-conducting structure: Refer to FIG. 5. FIG. 5 is another top view of the position relationship between the heat transfer plate 120, the second chip 20, and the first heat-conducting structure 30 in FIG. 2. The first heat-conducting structure 30 includes a first heat-conducting portion 301. The first heat-conducting portion 301 extends in a first direction, and the first direction is parallel to a plane on which the heat transfer plate 120 is located. There are a plurality of second chips 20. Two second chips 20 are as an example for illustration in FIG. 5. The plurality of second chips 20 are arranged in the first direction, and the plurality of second chips 20 are located on a same side of the first heat-conducting portion 301.

Based on Example 1 of the first heat-conducting structure 30, for example, still refer to FIG. 5. The first heat-conducting structure 30 further includes a second heat-conducting portion 302, and the second heat-conducting portion 302 extends in the first direction. In a second direction, the plurality of second chips 20 are located between the first heat-conducting portion 301 and the second heat-conducting portion 302, and the second direction intersects with the first direction.

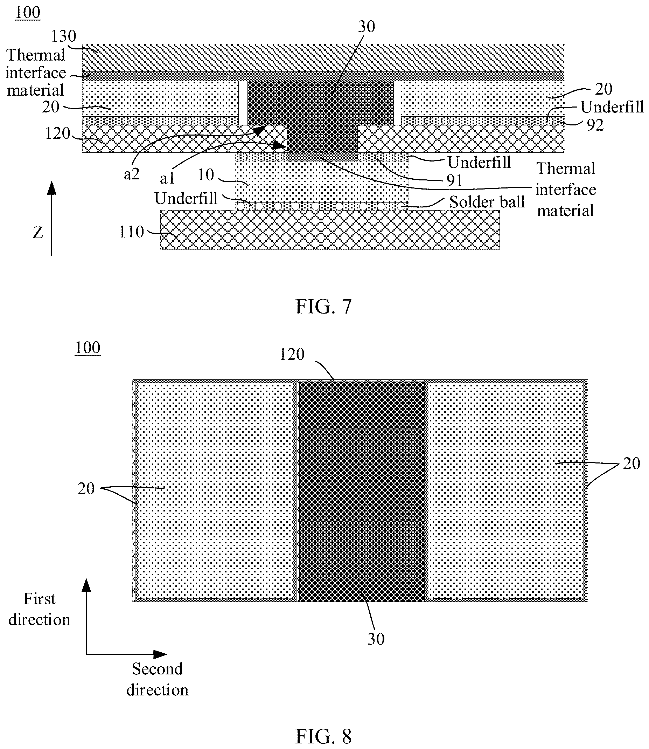

FIG. 6 is a diagram of a structure of another electronic assembly 100 according to an embodiment of this application. FIG. 7 is a diagram of a structure of still another electronic assembly 100 according to an embodiment of this application. FIG. 8 is a top view of a position relationship between a heat transfer plate 120, a second chip 20, and a first heat-conducting structure 30 in FIG. 6 or FIG. 7.

Example 2 of the first heat-conducting structure: Refer to FIG. 6 and FIG. 8. There are a plurality of second chips 20, and the first heat-conducting structure 30 may be located between at least two of the second chips 20.

Based on Example 2 of the first heat-conducting structure, for example, refer to FIG. 7. The heat transfer plate 120 includes an opening, and the first heat-conducting structure 30 passes through the opening and is connected to the first chip 10. In this example, the first heat-conducting structure 30 may be directly connected to the first chip 10. This helps further reduce thermal resistance between the first chip 10 and the first heat-dissipation heat sink 130, and improve heat dissipation efficiency.

For example, a thermal interface material is filled between the first heat-conducting structure 30 and the first chip 10. The thermal interface material has a high heat transfer coefficient, so that heat transfer efficiency between the first chip 10 and the first heat-conducting structure 30 can be increased, and heat dissipation effect of the first chip 10 can be improved.

For example, the heat transfer plate 120 includes a first contact surface a1 and a second contact surface a2. The first contact surface a1 is an inner wall surface of the opening. The second contact surface a2 is located on a side that is of the heat transfer plate 120 and that faces away from the first chip 10, and the second contact surface a2 may surround the opening. The first heat-conducting structure 30 may be connected to at least one of the first contact surface a1 and the second contact surface a2. A connection manner herein includes but is not limited to direct contact, adhesive bonding, soldering, or the like. In this example, when the first heat-conducting structure 30 is connected to the first contact surface a1 and/or the second contact surface a2, the thermal resistance between the first heat-conducting structure 30 and the heat transfer plate 120 can be reduced, and heat transfer efficiency can be improved.

In the foregoing, an example in which the heat transfer plate 120 is designed independent of the first chip 10 is used for description. In the following, a solution in which the heat transfer plate 120 is integrated into the first chip 10 is described.

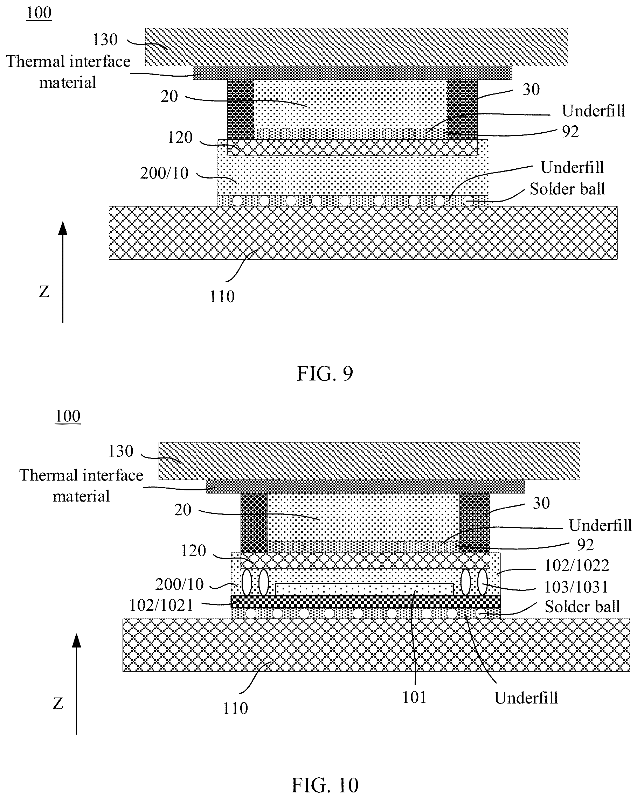

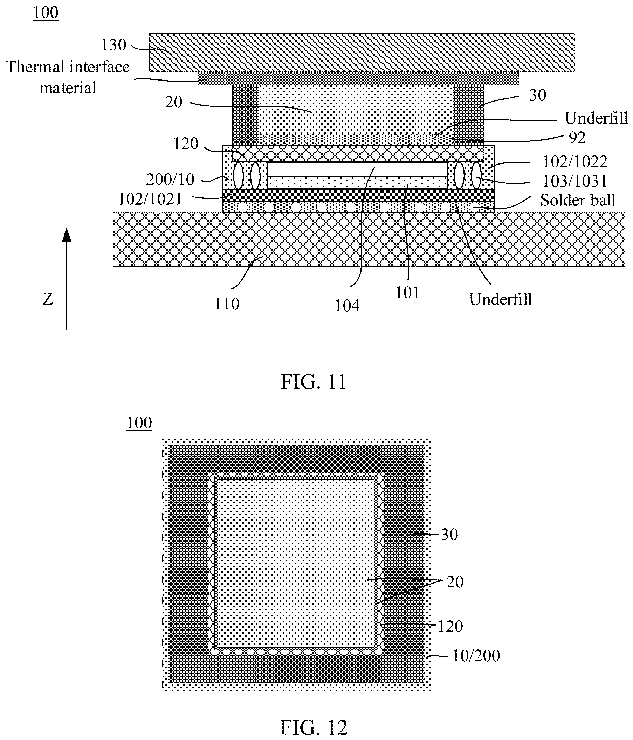

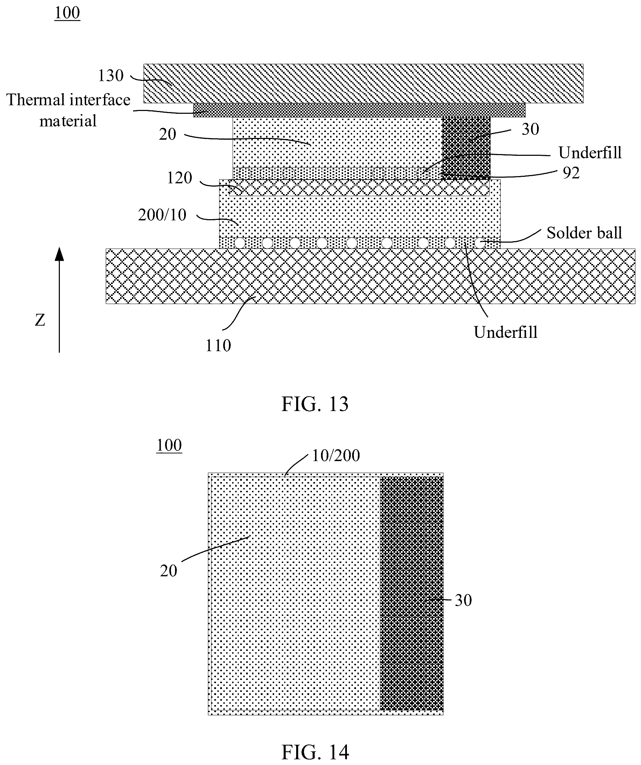

FIG. 9 is a diagram of a structure of still another electronic assembly 100 according to an embodiment of this application. FIG. 10 is a diagram of a structure of still another electronic assembly 100 according to an embodiment of this application. FIG. 11 is a diagram of a structure of still another electronic assembly 100 according to an embodiment of this application. FIG. 12 is a top view of a position relationship between a first chip 10, a second chip 20, and a first heat-conducting structure 30 in FIG. 9, FIG. 10, or FIG. 11. FIG. 13 is a diagram of a structure of still another electronic assembly 100 according to an embodiment of this application. FIG. 14 is a top view of a position relationship between a first chip 10, a second chip 20, and a first heat-conducting structure 30 in FIG. 13.

Refer to FIG. 9 and FIG. 13. An embodiment of this application provides a chip structure 200. Specifically, the foregoing heat transfer plate 120 is integrated into the chip structure 200. The chip structure 200 may be used as the first chip 10 in the electronic assembly 100. In the following, an example in which the chip structure 200 is the first chip 10 is used for description.

The first chip 10 may expose the heat dissipation surface 1210 (refer to FIG. 3) and the plurality of third contacts 1230 (refer to FIG. 3) of the heat transfer plate 120. That is, a surface that is of the first chip 10 and that faces away from the circuit board 110 includes the heat dissipation surface 1210 and the plurality of third contacts 1230 of the heat transfer plate 120. The heat dissipation surface 1210 may be configured to connect to the first heat-conducting structure 30, and the plurality of third contacts 1230 may be configured to connect to the second chip 20. In this embodiment, the heat transfer plate 120 is integrated into the chip structure 200. In this way, heat in the first chip 10 is more likely to be conducted out of the heat dissipation surface 1210 of the heat transfer plate 120, so that heat dissipation effect of the first chip 10 is improved.

Refer to FIG. 12 and FIG. 14. In the solution in which the heat transfer plate 120 is integrated into the first chip 10, for an arrangement manner of the first heat-conducting structure 30, refer to any one of the foregoing embodiments. For example, as shown in FIG. 12, the first heat-conducting structure 30 may still be disposed all around the second chip 20. For another example, as shown in FIG. 14, the first heat-conducting structure 30 may still be disposed on a side of the second chip 20. In another embodiment, the first heat-conducting structure 30 may alternatively be disposed on any one or more sides of the second chip 20. This is not limited in this application.

Refer to FIG. 10. In some embodiments, the chip structure 200 may include a first die 101, the heat transfer plate 120, and a first protection portion 102. The heat transfer plate 120 is disposed on a side of the first die 101. A surface that is of the heat transfer plate 120 and that faces away from the first die 101 includes the heat dissipation surface 1210 (refer to FIG. 3) and the plurality of third contacts 1230 (refer to FIG. 3). The heat dissipation surface 1210 is electrically insulated from the plurality of third contacts 1230. The first protection portion 102 surrounds the first die 101 and the heat transfer plate 120, and the first protection portion 102 exposes the heat dissipation surface 1210 and the third contacts 1230. In this way, heat in the first chip 10 is more likely to be conducted out of the heat dissipation surface 1210 of the heat transfer plate 120, so that heat dissipation effect of the first chip 10 is improved.

In some embodiments, as shown in FIG. 10, the first protection portion 102 includes a first packaging substrate 1021 and a first plastic packaging portion 1022. A surface that is of the first die 101 and that faces away from the heat transfer plate 120 is connected to the first packaging substrate 1021, and the first plastic packaging portion 1022 is connected to the first packaging substrate 1021 and at least surrounds a side surface of the first die 101 and all or a part of a surface that is of the heat transfer plate 120 and that faces away from the first die 101.

For example, the heat transfer plate 120 and the first packaging substrate 1021 may be connected in the BGA packaging manner or the LGA packaging manner.

For example, the chip structure 200 further includes a heat-conducting portion 103. The heat-conducting portion 103 is located in the first plastic packaging portion 1022, and the heat-conducting portion 103 is connected to the first packaging substrate 1021 and the heat transfer plate 120. The heat-conducting portion 103 may be a third solder ball 1031, and a plurality of third solder balls 1031 may be arranged. For example, at least one circle of third solder balls 1031 is arranged around the first die 101, and third solder balls 1031 in each circle are spaced apart.

In this embodiment, the heat-conducting portion 103 is disposed to connect the first packaging substrate 1021 and the heat transfer plate 120, so that heat in the first chip 10 is more likely to be transferred to the heat transfer plate 120, to be conducted to the first heat-conducting structure 30 and the first heat-dissipation heat sink 130 through the heat dissipation surface of the heat transfer plate 120. In this way, heat dissipation efficiency is improved.

For example, as shown in FIG. 11, the chip structure 200 further includes a connection plate 104. The connection plate 104 is stacked between the first die 101 and the heat transfer plate 120, and the connection plate 104 is in contact with both the first die 101 and the heat transfer plate 120.

In this example, the connection plate 104 is added, so that heat of the first die 101 can be better conducted to the heat transfer plate 120 with higher heat transfer efficiency, and the first chip 10 is less likely to have a junction temperature.

The chip structure 200 provided in this embodiment of this application may be used as the first chip 10 in the electronic assembly 100. When the electronic assembly 100 is formed, a separate heat transfer plate 120 does not need to be assembled again, and an assembly process is simpler.

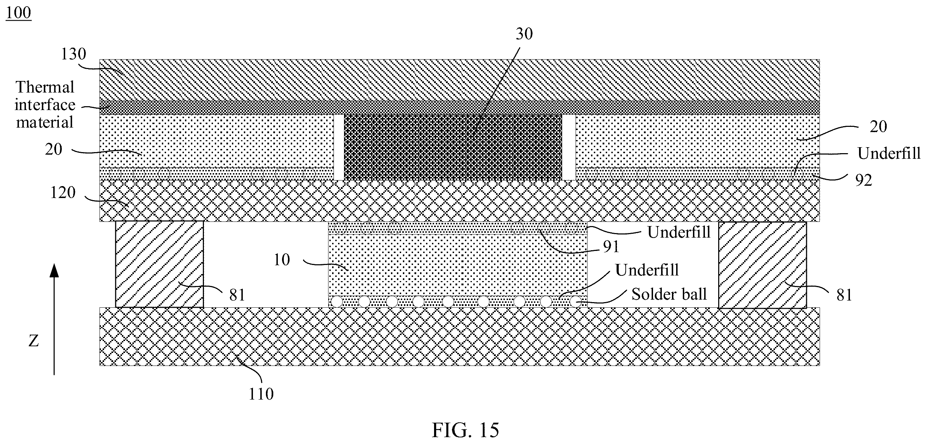

FIG. 15 is a diagram of a structure of still another electronic assembly 100 according to an embodiment of this application. In some embodiments, as shown in FIG. 15, the electronic assembly 100 further includes a support structure 81 located between the heat transfer plate 120 and the circuit board 110 and connected to both the heat transfer plate 120 and the circuit board 110. In this embodiment, the support structure 81 may be used to support the heat transfer plate 120 and improve reliability of the electronic assembly 100. The support structure 81 herein is not limited to metal, a non-metal material, a functional component, or the like. Connection between the support structure 81 and the heat transfer plate 120 is not limited to adhesive bonding, soldering, and direct physical contact. Connection between the support structure 81 and the circuit board 110 is not limited to adhesive bonding, soldering, and direct physical contact.

For example, the support structure 81 may be configured as a second heat-conducting structure. In this way, thermal interaction features of both the heat transfer plate 120 and the circuit board 110 can be improved, so that heat dissipation is enhanced.

For example, the support structure 81 may be disposed around the first chip 10. In this way, effect of supporting the heat transfer plate 120 by the support structure 81 can be improved, and stability and reliability are high.

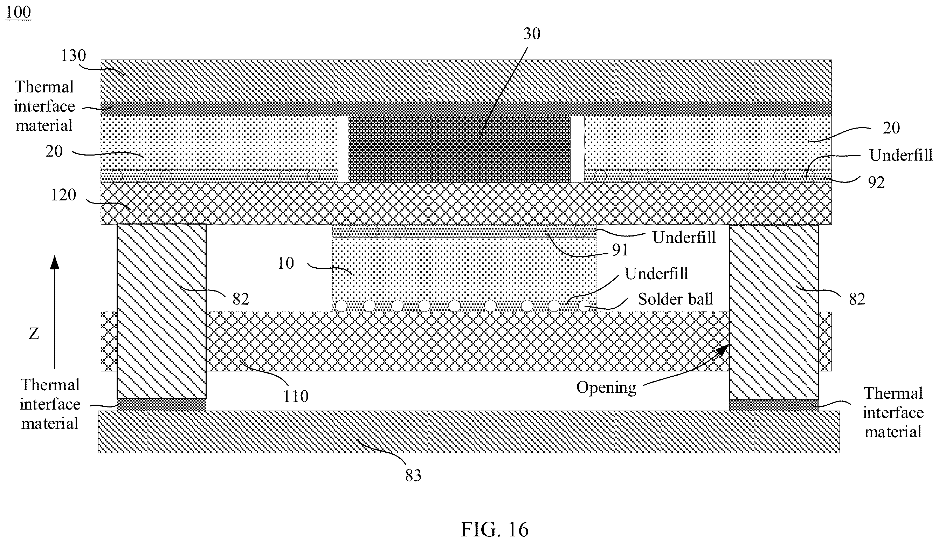

FIG. 16 is a diagram of a structure of still another electronic assembly 100 according to an embodiment of this application. In some embodiments, as shown in FIG. 16, the electronic assembly 100 further includes a third heat-conducting structure 82 and a second heat-dissipation heat sink 83. The second heat-dissipation heat sink 83 is located on a side that is of the circuit board 110 and that faces away from the heat transfer plate 120. The third heat-conducting structure 82 is located between the heat transfer plate 120 and the second heat-dissipation heat sink 83. The third heat-conducting structure 82 passes through an opening in the circuit board 110. One end of the third heat-conducting structure 82 is connected to the heat transfer plate 120, and the other end of the third heat-conducting structure 82 is connected to the second heat-dissipation heat sink 83. In this embodiment, the third heat-conducting structure 82 may pass through the circuit board 110, and directly implement thermal connection to the second heat-dissipation heat sink 83 on the side that is of the circuit board 110 and that faces away from the first chip 10, so that efficient heat transfer from the heat transfer plate 120 to the second heat-dissipation heat sink 83 on the side that is of the circuit board 110 and that faces away from the first chip 10 is implemented, to achieve heat dissipation effect. The third heat-conducting structure 82 herein is not limited to metal, non-metal, an alloy, or the like.

For example, the third heat-conducting structure 82 is disposed around the first chip 10. Herein, the third heat-conducting structure 82 can further well support the heat transfer plate 120.

For example, the third heat-conducting structure 82 is connected to the second heat-dissipation heat sink 83 through soldering or a thermal interface material. In this way, the third heat-conducting structure 82 and the second heat-dissipation heat sink 83 have high heat transfer efficiency.

For example, the third heat-conducting structure 82 and the second heat-dissipation heat sink 83 are of an integrated structure. In this way, the third heat-conducting structure 82 and the second heat-dissipation heat sink 83 have higher heat transfer efficiency.

In some embodiments, for the chip structure 200, refer to any one or more of the foregoing embodiments. At least one of the first heat-conducting structure 30, the support structure 81, and the third heat-conducting structure 82 is disposed on the chip structure 200. It should be noted that solutions in all embodiments of the first heat-conducting structure 30, the support structure 81, and the third heat-conducting structure 82 may be separately set, or may be set at the same time. That is, the embodiments may be combined, and a technical solution formed by combination shall fall within the protection scope of this application.

For the chip structure 200 and the electronic assembly 100, for example, the heat transfer plate 120 and at least one of the first heat-conducting structure 30, the support structure 81, and the third heat-conducting structure 82 may be further manufactured into an integrated structure (refer to the foregoing descriptions, and details are not described herein again), to further reduce thermal resistance and improve heat transfer performance.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic assembly, comprising: a circuit board, a first chip, a second chip, and a heat transfer plate, wherein the heat transfer plate is located on a side of the circuit board; and
the first chip is located between the heat transfer plate and the circuit board, the first chip is connected to the circuit board, the first chip is connected to the heat transfer plate, the second chip is located on a side that is of the heat transfer plate and that faces away from the circuit board, and the second chip is connected to the heat transfer plate.

2. The electronic assembly according to claim 1, wherein a surface of a side that is of the first chip and that is close to the heat transfer plate comprises a plurality of first contacts; and
the electronic assembly further comprises a plurality of first solder balls located between the heat transfer plate and the first chip, the heat transfer plate is connected to the plurality of first contacts through the plurality of first solder balls, and at least one of the plurality of first solder balls is not configured to transmit an electrical signal.

3. The electronic assembly according to claim 1 or 2, wherein a surface of a side that is of the second chip and that is close to the heat transfer plate comprises a plurality of second contacts; and
the electronic assembly further comprises a plurality of second solder balls located between the heat transfer plate and the second chip, the heat transfer plate is connected to the plurality of second contacts through the plurality of second solder balls, and at least one of the plurality of second solder balls is not configured to transmit an electrical signal.

4. The electronic assembly according to any one of claims 1 to 3, wherein the electronic assembly further comprises underfill filled between the heat transfer plate and the first chip and/or between the heat transfer plate and the second chip.

5. The electronic assembly according to claim 1, wherein the first chip comprises a first die and a first protection portion, the heat transfer plate is disposed on a side that is of the first die and that faces away from the circuit board, a surface that is of the heat transfer plate and that faces away from the circuit board comprises a heat dissipation surface and a plurality of third contacts, the heat dissipation surface is electrically insulated from the plurality of third contacts, the first protection portion surrounds the first die and the heat transfer plate, the first protection portion exposes the heat dissipation surface and the third contacts, and the plurality of third contacts are connected to the second chip.

6. The electronic assembly according to claim 5, wherein the first protection portion comprises a first packaging substrate and a first plastic packaging portion, a surface that is of the first die and that faces away from the heat transfer plate is connected to the first packaging substrate, and the first plastic packaging portion is connected to the first packaging substrate and at least surrounds a side surface of the first die and all or a part of a surface that is of the heat transfer plate and that is close to the first die; and
the first chip further comprises a heat-conducting portion, the heat-conducting portion is located in the first plastic packaging portion, and the heat-conducting portion is connected to the first packaging substrate and the heat transfer plate.

7. The electronic assembly according to claim 6, wherein
there is one or more heat-conducting portions, and at least one of the heat-conducting portions is configured to be capable of conducting an electrical signal.

8. The electronic assembly according to any one of claims 5 to 7, wherein
the first die is connected to the heat transfer plate; or
the first chip further comprises a connection plate, the connection plate is stacked between the first die and the heat transfer plate, and the connection plate is connected to both the first die and the heat transfer plate.

9. The electronic assembly according to any one of claims 1 to 4, wherein a surface that is of the heat transfer plate and that faces away from the circuit board comprises a heat dissipation surface and a plurality of third contacts, the heat dissipation surface is electrically insulated from the plurality of third contacts, and the plurality of third contacts are connected to the second chip.

10. The electronic assembly according to any one of claims 5 to 9, wherein the plurality of third contacts form at least one third contact group, the heat dissipation surface comprises a first heat dissipation surface, and the first heat dissipation surface is disposed around at least one side of the third contact group.

11. The electronic assembly according to any one of claims 5 to 10, wherein the heat dissipation surface further comprises a second heat dissipation surface; and
the heat transfer plate comprises a via, the heat transfer plate comprises a heat transfer portion located in the via, and the heat transfer portion comprises the second heat dissipation surface.

12. The electronic assembly according to any one of claims 5 to 11, further comprising a first heat-dissipation heat sink and a first heat-conducting structure, wherein
the first heat-dissipation heat sink is located on a side that is of the second chip and that faces away from the heat transfer plate; and
the first heat-conducting structure is connected to the heat dissipation surface of the heat transfer plate and the first heat-dissipation heat sink.

13. The electronic assembly according to claim 12, wherein the first heat-conducting structure is connected to the heat dissipation surface of the heat transfer plate through soldering or a thermal interface material; or
the first heat-conducting structure and the heat transfer plate are of an integrated structure.

14. The electronic assembly according to claim 12 or 13, wherein
a thermal interface material is filled between the first heat-dissipation heat sink and the first heat-conducting structure, or the first heat-dissipation heat sink and the first heat-conducting structure are of an integrated structure; and/or
a thermal interface material is filled between the first heat-dissipation heat sink and the second chip.

15. The electronic assembly according to any one of claims 12 to 14, wherein
the first heat-conducting structure is located between the heat transfer plate and the first heat-dissipation heat sink, and the first heat-conducting structure is located on at least one side of the second chip.

16. The electronic assembly according to claim 15, wherein
the first heat-conducting structure comprises a first heat-conducting portion, the first heat-conducting portion extends in a first direction, and the first direction is parallel to a plane on which the heat transfer plate is located; and
there are a plurality of second chips, the plurality of second chips are arranged in the first direction, and the plurality of second chips are located on a same side of the first heat-conducting portion.

17. The electronic assembly according to claim 16, wherein the first heat-conducting structure further comprises a second heat-conducting portion, and the second heat-conducting portion extends in the first direction; and
in a second direction, the plurality of second chips are located between the first heat-conducting portion and the second heat-conducting portion, and the second direction intersects with the first direction.

18. The electronic assembly according to claim 17, wherein
there are a plurality of second chips, and the first heat-conducting structure is located between at least two of the second chips.

19. The electronic assembly according to claim 18, wherein
the heat transfer plate comprises an opening; and
the first heat-conducting structure passes through the opening and is connected to the first chip.

20. The electronic assembly according to claim 19, wherein
a thermal interface material is filled between the first heat-conducting structure and the first chip.

21. The electronic assembly according to claim 19 or 20, wherein
the heat transfer plate comprises a first contact surface and a second contact surface;
the first contact surface is an inner wall surface of the opening, the second contact surface is located on a side that is of the heat transfer plate and that faces away from the first chip, and the second contact surface surrounds the opening; and
the first heat-conducting structure is connected to at least one of the first contact surface and the second contact surface.

22. The electronic assembly according to any one of claims 1 to 21, further comprising:
a support structure located between the heat transfer plate and the circuit board and connected to both the heat transfer plate and the circuit board.

23. The electronic assembly according to claim 22, wherein
the support structure is configured as a second heat-conducting structure, and the second heat-conducting structure and the heat transfer plate are of an integrated structure; and/or
the support structure is disposed around the first chip.

24. The electronic assembly according to any one of claims 1 to 23, further comprising a third heat-conducting structure and a second heat-dissipation heat sink, wherein
the second heat-dissipation heat sink is located on a side that is of the circuit board and that faces away from the heat transfer plate; and
the third heat-conducting structure is located between the heat transfer plate and the second heat-dissipation heat sink, the third heat-conducting structure passes through an opening in the circuit board, one end of the third heat-conducting structure is connected to the heat transfer plate, and the other end of the third heat-conducting structure is connected to the second heat-dissipation heat sink.

25. The electronic assembly according to claim 24, wherein the third heat-conducting structure is disposed in at least one of the following manners:
the third heat-conducting structure is disposed around the first chip;
the third heat-conducting structure is connected to the second heat-dissipation heat sink through soldering or a thermal interface material, or the third heat-conducting structure and the second heat-dissipation heat sink are of an integrated structure; or
the third heat-conducting structure and the heat transfer plate are of an integrated structure.

26. A chip structure, comprising a first die, a heat transfer plate, and a first protection portion, wherein the heat transfer plate is disposed on a side of the first die, a surface that is of the heat transfer plate and that faces away from the first die comprises a heat dissipation surface and a plurality of third contacts, the heat dissipation surface is electrically insulated from the plurality of third contacts, the first protection portion surrounds the first die and all or a part of a surface that is of the heat transfer plate and that is close to the first die, and the first protection portion exposes the heat dissipation surface and the third contacts.

27. The chip structure according to claim 26, wherein the first protection portion comprises a first packaging substrate and a first plastic packaging portion, a surface that is of the first die and that faces away from the heat transfer plate is connected to the first packaging substrate, and the first plastic packaging portion is connected to the first packaging substrate and at least surrounds a side surface of the first die and all or a part of the surface that is of the heat transfer plate and that is close to the first die; and
the first chip further comprises a heat-conducting portion, the heat-conducting portion is located in the first plastic packaging portion, and the heat-conducting portion is connected to the first packaging substrate and the heat transfer plate.

28. The chip structure according to claim 27, wherein
there is one or more heat-conducting portions, and at least one of the heat-conducting portions is configured to be capable of conducting an electrical signal.

29. The chip structure according to any one of claims 26 to 28, wherein
the first die is connected to the heat transfer plate; or
the first chip further comprises a connection plate, the connection plate is stacked between the first die and the heat transfer plate, and the connection plate is connected to both the first die and the heat transfer plate.

30. The chip structure according to any one of claims 26 to 29, further comprising:
a first heat-conducting structure located on the surface that is of the heat transfer plate and that faces away from the first die, and the first heat-conducting structure and the heat transfer plate are of an integrated structure;
a second heat-conducting structure located on a surface that is of the heat transfer plate and that faces the first die, and the second heat-conducting structure and the heat transfer plate are of an integrated structure; or
a third heat-conducting structure located on a surface that is of the heat transfer plate and that faces the first die, and the third heat-conducting structure and the heat transfer plate are of an integrated structure.

31. An electronic device, comprising the electronic assembly according to any one of claims 1 to 25, or the chip structure according to any one of claims 26 to 30.
